# EUROPEAN PATENT APPLICATION

(11) **EP 2 174 910 A1**
(43) Date of publication of application: **14.04.2010**
(21) Application number: 09172609.1
(22) Date of filing: 09.10.2009
(51) Int. Cl.: C01B 31/02, H01B 1/18, H05K 1/09

(54) **High conductive paste composite and method of producting the same**

(30) Priority: 09.10.2008 KR 20080099066
(71) Applicant: Exaenc Corp., Mokcheon-eup, Cheonan-si Chungcheongnam-do (KR)
(72) Inventor: Lee, Tack-Soo, Chungcheongnam-do (KR); Kang, Seung-Kyung, Gyeonggi-do (KR); Kim, Chul-Ki, Chungcheongnam-do (KR)
(74) Representative: Grünecker, Kinkeldey, Stockmair & Schwanhäusser Anwaltssozietät

(57) **Abstract**

The present inventive concept relates to a high conductive paste composite which can minimally undergo effects of a negative temperature resistance coefficient (e.g., heat radiation effect 5 to 10 times larger than that of copper or aluminum, high field emission effect, black body radiation, etc.) that the carbon nano tube has in the case of products using the carbon nano tube (MWNT or SWNT), which can solve problems (negative temperature resistance coefficient and high resistance) of a heating part (conductive carbon paste) that converts electric energy of a heating body into thermal energy.

## Description

### CROSS-REFERENCE TO RELATED APPLICATIONS

This application claims the benefit of Korean Patent Application No. 10-2008-0099066, filed on 9 October, 2008, in the Korean Intellectual Property Office, the disclosure of which is incorporated herein in its entirety by reference.

### BACKGROUND

The inventive concept relates to a high conductive paste composite including a carbon nano tube (CNT) having a functional group of "-COOR," a method of producing the same, a resistor film including the high conductive paste composite, and an electronic part.

A general conductive paste includes a conductive material (conductive carbon, graphite), an organic binder, a thinner, etc. The conductive paste is printed on an adherend (poly ethylene terephthalate (PET) film, a ceramic substrate) by a certain pattern through silk screen printing, gravure printing, etc., and forms a film as being dried at a temperature equal to or higher than the boiling point of the thinner.

The pattern formed in this manner generates heat when electricity is applied to opposite ends thereof. The resistance of a heating element may depend on the resistance of the conductive paste, i.e., a mixture ratio of the conductive material and the binder and be adjusted by adjusting the film thickness, the width and the length of the conductive material.

However, the mechanical properties of the conductive paste deteriorate as the film of the conductive material becomes thicker. Thus, there is a limit to make the film of the conductive material thicker.

Further, the conductivity can be increased by increasing the content of the conductive material. However, the content of the conductive material is limited because the conductive material has large oil-absorption and difficulty with dispersing, and it is difficult to achieve the high conductivity in light of the content.

### SUMMARY

The inventive concept provides a high conductive paste composite including a surface-treated carbon nano tube (CNT) to have a low resistance and a stable temperature resistance coefficient, a method of producing the same, a resistor film including the high conductive paste composite, and an electronic part.

The inventive concept is not limited to the aforementioned concept, and other concepts will be clearly understood by those skilled in the art through the following descriptions.

According to an aspect of the inventive concept, there is provided a high conductive paste composite including 1 to 10 parts by weight of a carbon nano tube (CNT) having a functional group of "-COOR(where, R is an alkyl group of 1 to 20 carbon atoms, an aryl group of 6 to 20 carbon atoms, an alkenyl group of 2 to 20 carbon atoms, or an alkynyl group of 2 to 20 carbon atoms)" with respect to 100 parts by weight of a total composite.

According to another aspect of the inventive concept, there is provided a method of producing a high conductive paste, the method including a) forming a carbon nano tube (CNT) having a functional group of "-COOR" by introducing the functional group of "-COOR" (where, R is an alkyl group of 1 to 20 carbon atoms, an aryl group of 6 to 20 carbon atoms, an alkenyl group of 2 to 20 carbon atoms, or an alkynyl group of 2 to 20 carbon atoms )" into the carbon nano tube, which includes a1) applying acid treatment to the carbon nano tube and a2) performing esterification by adding polyhydric alcohol (polyol) to the acid-treated carbon nano tube; and b) mixing the carbon nano tube having the functional group of "-COOR" prepared at the a) with an organic binder.

According to an aspect of the inventive concept, there is provided a resistor film comprising the high conductive paste composite.

According to an aspect of the inventive concept, there is provided an electronic part comprising the resistor film.

### BRIEF DESCRIPTION OF THE DRAWINGS

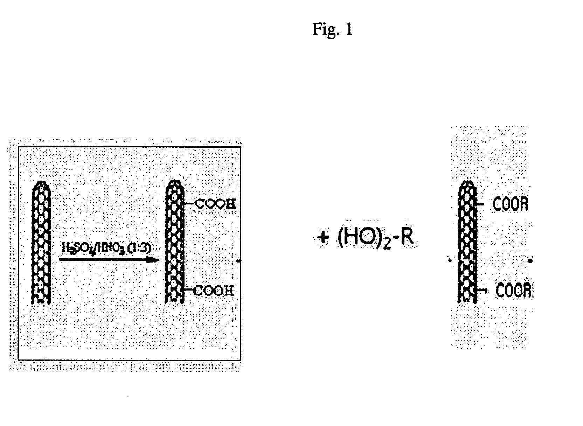

Exemplary embodiments of the inventive concept will be more clearly understood from the following detailed description taken in conjunction with the accompanying drawings in which FIG. 1 shows a process of introducing a functional group of "-COOR" into a carbon nano tube (CNT) according to an exemplary embodiment of the present inventive concept.

### DETAILED DESCRIPTION OF THE EMBODIMENTS

The attached drawings for illustrating embodiments of the inventive concept are referred to in order to gain a sufficient understanding of the inventive concept and the merits thereof.

Hereinafter, the inventive concept will be described in detail by explaining embodiments of the inventive concept with reference to the attached drawings. Like reference numerals in the drawings denote like elements.

A high conductive paste composite according to an exemplary embodiment is characterized in including 1 to 10 parts by weight of a carbon nano tube (CNT) having a functional group of "-COOR (where, R is an alkyl group of 1 to 20 carbon atoms, an aryl group of 6 to 20 carbon atoms, an alkenyl group of 2 to 20 carbon atoms, or an alkynyl group of 2 to 20 carbon atoms)" with respect to 100 parts by weight of the total composite. Here, the CNT having the functional group of "-COOR" is prepared by applying surface treatment to the CNT.

The CNT per se is a good conductive material as compared with general conductive carbon, but has better conductivity as undergoing the surface treatment since it is dispersed to a binder by the Van der Waals' force. Thus, the conductive paste with the CNT, the surface of which is treated, has higher conductivity than that with the CNT, the surface of which is not treated. Further, this conductive paste has a lower temperature-resistance coefficient than the general conductive carbon, so that a high conductive paste composite can have a stable temperature-resistance coefficient.

Here, the kind of the CNT to undergo the surface treatment is not limited, but may have a specific surface area of 100 to 600m²/g.

For example, the CNT may be selected among a multi-walled nano tube (MWNT), a single-walled nano tube (SWNT), and a thin-walled nano tube (TWNT). Specifically, the CNT may be at least one selected between the MWNT and the SWNT which are most useful since thermal conductivity and electric conductivity are excellent and relatively suitable for a material of a heating element because oxidation temperature is relatively high.

In more detail, the surface-treated CNT can have the high conductivity through an electric network phenomenon of the CNT since the Van der Waals' force of the CNT becomes weakened as the functional group of "-COOR" is introduced to the CNT by esterification after applying acid treatment to the CNT.

As described above, the CNT having the functional group of "-COOR" is produced by applying the surface treatment to the CNT, in which the functional group of "-COOR" is introduced after the surface of the CNT is treated.

Specifically, the CNT having the functional group of "-COOR" is achieved by introducing the foregoing functional group to the CNT through the esterification using polyhydric alcohol (polyol) after applying the acid treatment to the CNT. Here, "R" in the functional group of "-COOR" may be methyl methacrylate or ethylene tetephtalate as 10 or more repeating units by way of example.

Here, the polyol may be glycol or glycerol, for example, methyl methacrylate diol and ester terephthalate diol. Here, the polyol indicates alcohol having two or more alcoholic hydroxyl groups of "-OH" in a molecule.

Below, the acid treatment and the esterification with the polyol will be described in more detail with reference to FIG. 1.

If the CNT undergoes the acid treatment, a "- OH" group or a carboxyl group (-COOH) are introduced on to the surface of the CNT.

Here, the acid treatment, for example, a process of introducing the carboxyl group as the functional group is as follows. The MWNT (as an example of the CNT) is added to a solution where H₂SO₄ and HNO₃ are mixed at a volume ratio of 3:1, and refluxed at 140°C for 30 minutes. Then, it is repetitively cleaned and filtered using deionized water until the solution shows a pH of about 7∼8, and then dried to thereby obtain the acid-treated MWNT. Through these processes, the "-COOH" group is provided on the surface of the CNT.

Next, the esterification using the polyhydric alcoholic material is applied to the "-COOH" group formed on the surface of the MWNT, thereby introducing the functional group of "-COOR." Besides, if it is also tried to introduce the functional group to the "-OH" group formed on the surface of the MWNT, the functional group can be introduced by applying fatty acid to the "-OH" group formed on the surface of the MWNT and using the esterification.

Here, the esterification using the polyhydric alcoholic material when the "-COOH" group is introduced into the surface of the MWNT is as follows. The MWNT having the "-COOH" group on the surface thereof is added to liquid polyol having a volume five times larger than that of the MWNT, and then H₂SO₄ is added thereto. Thereafter, it is refluxed for two hours at a temperature of 60°C, added with 5% sodium bicarbonate, and rotated until CO₂ is generated. Then, a precipitate is removed from a reactant through centrifugation, and a small quantity of anhydrous sodium sulfate is added to the reactant, thereby completely removing water.

After the foregoing process, the functional group of "-COOR" is introduced on to the surface of the CNT (refer to FIG. 1). Here, the functional group may be attached to a carbon structure including the CNT.

In short, after the acid treatment of the CNT, the functional group of "-COOR" is introduced into the surface of the CNT, where the "-COOH" group is attached, as the polyol becomes the functional group through the esterification. Also, after the acid treatment of the CNT, the functional group of "-COOR" is introduced into the surface of the CNT, where the "-OH" group is attached, as the fatty acid becomes the functional group through the esterification.

The CNT having the functional group occupies a very large volume ratio of the high conductive paste composite in consideration of its weight, so that the composite can maintain viscosity even though the composite contains it a little.

In this embodiment, the high conductive paste composite can include only the CNT, but not limited thereto. Alternatively, the high conductive paste composite may include graphite in addition to the CNT.

If both the CNT and the graphite are used, activity and usability are more improved than those of when only the CNT is used.

In this case, for example, the high conductive paste composite may include 1 to 10 parts by weight of the CNT having the functional group of "-COOR" and 10 to 20 parts by weight of the graphite.

10 to 20 parts by weight of the graphite causes the high conductive paste composite to have a low resistance. Also, the CNT, of which the surface is treated and to which the functional group is attached, becomes easier to disperse as adjusting the resistance, and it is therefore possible to achieve the low resistance since the additive of the same amount can be increased.

The high conductive paste composite may further include 70 to 80 parts by weight of an organic binder with respect to 100 parts by weight of the total composite.

Thus, for example, the high conductive paste composite in this embodiment may include 1 to 10 parts by weight of the CNT into which polyol is introduced as the functional group, 10 to 20 parts by weight of the graphite, and 70 to 89 parts by weight of the organic binder.

The organic binder facilitates dispersion of each component in the paste composite and provides viscosity suitable for securing the uniformity of a printed film when the high conductive paste composite undergoes silk screen printing.

As an example of the organic binder, a cellulose derivate such as acrylate, ethyl cellulose, methyl cellulose, nitro cellulose, carboxymethyl cellulose, etc. and a resin component such as acrylic ester, methacrylic acid ester, poly vinyl alcohol, poly vinyl butyral, etc. may be used without limitation. Preferably, an acrylic resin may be used as the organic binder, but not limited thereto.

According to the present inventive concept, a solvent such as cyclohexanone, Anon or butyl acetate, butyl cellosolve acetate, etc. may be added to the high conductive paste composite in order to adjust the viscosity.

For example, the high conductive paste composite in this embodiment may include 1 to 10 parts by weight of the CNT into which the "-COOR" is introduced as the functional group, 10 to 20 parts by weight of the graphite, and 70 to 89 parts by weight of the organic binder. If this mixture is 90 parts by weight with respect to 100 parts by weight of the total composite, 10 parts by weight of the solvent may be added in producing the high conductive paste composite. If this mixture is 40 parts by weight, 60 parts by weight of the solvent may be added.

In the high conductive paste composite according to the present inventive concept, conductivity is generally equal to or less than 30Ω/sq, but not limited thereto.

The high conductive paste composite according to the present inventive concept may be printed on an adherend through the silk screen printing or gravure printing, and form a resistor film.

Then, the resistor film may be used in various electronic parts since the resistance thereof can be freely adjusted. For example, the resistor can be used as a heating body of a heating product such as a film heating element, a mirror heating element, etc.

A method of producing the high conductive paste composite according to the present inventive concept includes a) forming the CNT having the functional group of "-COOR" by introducing the functional group of "-COOR" (where, R is an alkyl group of 1 to 20 carbon atoms, an aryl group of 6 to 20 carbon atoms, an alkenyl group of 2 to 20 carbon atoms, or an alkynyl group of 2 to 20 carbon atoms )" into the CNT, which includes a1) applying the acid treatment to the CNT and a2) performing the esterification by adding polyol to the acid-treated CNT; and b) mixing the CNT having the functional group of "-COOR" prepared at the step of a) with the organic binder. Of course, the subject matters described in the foregoing embodiments are all applied herein.

In the step of a1), it is **characterized in that** the acid treatment may be achieved by adding the CNT to the solution where H₂SO₄ and HNO₃ are mixed at a volume ratio of 3:1.

In the step of a2), the CNT having the functional group of "-COOR" can be produced through the esterification achieved by adding the CNT, into which the carboxy group of "-COOH" is introduced by the acid treatment of the a1) step, to the liquid polyol.

The polyol may be glycol or glycerol. Specifically, polyol may be methyl methacrylate diol and ester terephthalate diol.

The CNT having the functional group of "-COOR" may be at least one CNT selected between the MWNT and the SWNT.

In the step of b), 1 to 10 parts by weight of the CNT having the functional group of "-COOR" and 90 to 99 parts by weight of the organic binder may be mixed with respect to 100 parts by weight of the total composite.

In the step of b), the graphite may further be added. In the step of b), 1 to 10 parts by weight of the CNT having the functional group of "-COOR," 70 to 89 parts by weight of the organic binder, and 10 to 20 parts by weight of the graphite may be mixed with respect to 100 parts by weight of the total composite.

In the step of b), if the mixture is 40 to 90 parts by weight with respect to 100 parts by weight of the total composite, 10 to 60 parts by weight of the solvent can be added.

Below, the present inventive concept will be described through embodiments. However, the present inventive concept is not limited to the following embodiments, and may be changed by a person having an ordinary skill in the art within a scope disclosed in claims.

Embodiment 1

The high conductive paste composite was produced by adding a solvent of 10 parts by weight of cyclohexanone as a thinner to 5 parts by weight of the MWNT having the functional group of "-COOR (where, R is methyl methacrylate), 20 parts of weight of the graphite, and 75 parts by weight of acrylic resin as the organic binder to thereby adjust the viscosity, and then dispersing and mixing them with a three-step roll. Here, if the total composite containing the MWNT, the graphite, the organic binder and cyclo hexanone is 100 parts by weight, the mixture of the MWNT, the graphite and the organic binder is 90 parts by weight with respect to. Therefore, 10 parts by weight of cyclo haxanone were added to complete 100 parts by weight.

The high conductive paste composite was printed on a PET film through a screen printing method to form a film, and then it was dried for 10 minutes at a temperature of 135°C. At this time, the thickness of the film was about 12µm. Then, an electrode layer was formed on such a resistor film, and a laminating film was coated thereon, thereby obtaining a heating element.

While applying an alternating current (AC) voltage of 220V to opposite ends of the electrode layer of the heating element, the current was measured at a maximum saturated temperature region through the HIOKI 3280-10 digital Multimeter, thereby measuring a resistance at an initial state and a resistance when generating heat. The results were tabulated in the following table 1.

Embodiment 2

The high conductive paste composite was produced by adding a solvent of 10 parts by weight of cyclohexanone as a thinner to 10 parts by weight of the MWNT having the functional group of "-COOR (where, R is methyl methacrylate), 20 parts of weight of the graphite, and 70 parts by weight of acrylic resin as the organic binder to thereby adjust the viscosity, and then dispersing and mixing them with a three-step roll. Here, if the total composite containing the MWNT, the graphite, the organic binder and cyclo hexanone is 100 parts by weight, the mixture of the MWNT, the graphite and the organic binder is 90 parts by weight with respect to. Therefore, 10 parts by weight of cyclo haxanone were added to complete 100 parts by weight.

The high conductive paste composite was printed on a PET film through a screen printing method to form a film, and then it was dried for 10 minutes at a temperature of 135°C. At this time, the thickness of the film was about 12µm. Then, an electrode layer was formed on such a resistor film, and a laminating film was coated thereon, thereby obtaining a heating element.

While applying an AC voltage of 220V to opposite ends of the electrode layer of the heating element, the current was measured at a maximum saturated temperature region through the HIOKI 3280-10 digital Multimeter, thereby measuring a resistance at an initial state and a resistance when generating heat. The results were tabulated in the following table 1.

Comparative example 1

The paste composite was produced by adding 10 parts by weight of a thinner to 5 parts by weight of the general MWNT having no functional group, 20 parts of weight of the graphite, and 65 parts by weight of acrylic resin as the organic binder to thereby adjust the viscosity, and then dispersing and mixing them with a three-step roll.

The paste composite was printed on a PET film through a screen printing method to form a film, and then it was dried for 10 minutes at a temperature of 135°C. At this time, the thickness of the film was about 12µm. Then, an electrode layer was formed on such a resistor film, and a laminating film was coated thereon, thereby obtaining a heating element.

While applying an AC voltage of 220V to opposite ends of the electrode layer of the heating element, the current was measured at a maximum saturated temperature region through the HIOKI 3280-10 digital Multimeter, thereby measuring a resistance at an initial state and a resistance when generating heat. The results were tabulated in the following table 1.

Comparative example 2

The paste composite was produced by adding 10 parts by weight of a thinner to 10 parts by weight of the general MWNT having no functional group, 20 parts of weight of the graphite, and 60 parts by weight of acrylic resin as the organic binder to thereby adjust the viscosity, and then dispersing and mixing them with a three-step roll.

The paste composite was printed on a PET film through a screen printing method to form a film, and then it was dried for 10 minutes at a temperature of 135°C. At this time, the thickness of the film was about 12µm. Then, an electrode layer was formed on such a resistor film, and a laminating film was coated thereon, thereby obtaining a heating element.

While applying an AC voltage of 220V to opposite ends of the electrode layer of the heating element, the current was measured at a maximum saturated temperature region through the HIOKI 3280-10 digital Multimeter, thereby measuring a resistance at an initial state and a resistance when generating heat. The results were tabulated in the following table 1.

Comparative example 3

The paste composite was produced by adding 10 parts by weight of a thinner to 5 parts by weight of conductive carbon black, 20 parts of weight of the graphite, and 65 parts by weight of acrylic resin as the organic binder to thereby adjust the viscosity, and then dispersing and mixing them with a three-step roll.

The paste composite was printed on a PET film through a screen printing method to form a film, and then it was dried for 10 minutes at a temperature of 135°C. At this time, the thickness of the film was about 12µm. Then, an electrode layer was formed on such a resistor film, and a laminating film was coated thereon, thereby obtaining a heating element.

While applying an AC voltage of 220V to opposite ends of the electrode layer of the heating element, the current was measured at a maximum saturated temperature region through the HIOKI 3280-10 digital Multimeter, thereby measuring a resistance at an initial state and a resistance when generating heat. The results were tabulated in the following table 1.

Comparative example 4

The paste composite was produced by adding 10 parts by weight of a thinner to 10 parts by weight of conductive carbon black, 20 parts of weight of the graphite, and 60 parts by weight of acrylic resin as the organic binder to thereby adjust the viscosity, and then dispersing and mixing them with a three-step roll.

The paste composite was printed on a PET film through a screen printing method to form a film, and then it was dried for 10 minutes at a temperature of 135 °C. At this time, the thickness of the film was about 12µm. Then, an electrode layer was formed on such a resistor film, and a laminating film was coated thereon, thereby obtaining a heating element.

While applying an AC voltage of 220V to opposite ends of the electrode layer of the heating element, the current was measured at a maximum saturated temperature region through the HIOKI 3280-10 digital Multimeter, thereby measuring a resistance at an initial state and a resistance when generating heat. The results were tabulated in the following table 1.

**Table 1**

| | Measured Resistance (Ω) | |
|---|---|---|
| | Resistance at initial state | Resistance when generating heat |
| Embodiment 1 | 802 | 800 |
| Embodiment 2 | 520 | 517 |
| Comparative Example 1 | 1204 | 1200 |
| Comparative Example 2 | 893 | 890 |
| Comparative Example 3 | 1897 | 1792 |
| Comparative Example 4 | 1197 | 947 |

Referring to the table 1, although the embodiment 1 and the comparative examples 1 and 3 are different in a conductive material (i.e., the MWNT and the conductive carbon black) from one another, but they were added by the same amount (i.e., 5 parts by weight). In comparison among the embodiment 1 and the comparative examples 1 and 3, under the condition that the additive amounts thereof are equal to one another, the resistance in the case of adding the MWNT is lower than that in the case of adding the conductive carbon black, and further the resistance in the case of adding the MWNT having the functional group is lower than that in the case of adding the MWNT having no functional group.

Similarly, the embodiment 1 and the comparative examples 2 and 4 also show the like results. That is, resistance variation of when the MWNT generates heat is less than that of when the conductive carbon black generates heat.

Thus, the embodiments according to the present inventive concept show that the high conductive paste composite with the CNT having the functional group can have a further low resistance as compared with the same content.

As described above, according to the present inventive concept, there is provided a high conductive paste composite having a low surface-resistance and a low temperature-resistance coefficient, in which the surface-resistance and the temperature resistance coefficient are less affected by the size of a resistor, and which can be employed as various heating elements.

While the inventive concept has been particularly shown and described with reference to exemplary embodiments thereof, it will be understood that various changes in form and details may be made therein without departing from the spirit and scope of the following claims.

## Claims

1. A high conductive paste composite comprising 1 to 10 parts by weight of a carbon nano tube (CNT) having a functional group of "-COOR(where, R is an alkyl group of 1 to 20 carbon atoms, an aryl group of 6 to 20 carbon atoms, an alkenyl group of 2 to 20 carbon atoms, or an alkynyl group of 2 to 20 carbon atoms)" with respect to 100 parts by weight of a total composite.

2. The high conductive paste composite according to claim 1, wherein the carbon nano tube having the functional group of "-COOR" is achieved by introducing the functional group into the carbon nano tube through esterification using polyhydric alcohol (polyol) after applying acid treatment to the carbon nano tube.

3. The high conductive paste composite according to claim 2, wherein the polyhydric alcohol comprises methyl methacrylate diol and ester terephthalate diol.

4. The high conductive paste composite according to claim 1, wherein the carbon nano tube having the functional group of "-COOR" comprises at least one carbon nano tube selected between a multi-walled nano tube (MWNT) and a single-walled nano tube (SWNT).

5. The high conductive paste composite according to claim 1, further comprising 10 to 20 parts by weight of graphite with respect to 100 parts by weight of the total composite.

6. The high conductive paste composite according to claim 1, further comprising 70 to 80 parts by weight of an organic binder with respect to 100 parts by weight of the total composite.

7. A resistor film comprising the high conductive paste composite according to any one of claims 1 through 6.

8. An electronic part comprising the resistor film according to claim 7.

9. A method of producing a high conductive paste, the method comprising
a) forming a carbon nano tube (CNT) having a functional group of "-COOR" by introducing the functional group of "-COOR" (where, R is an alkyl group of 1 to 20 carbon atoms, an aryl group of 6 to 20 carbon atoms, an alkenyl group of 2 to 20 carbon atoms, or an alkynyl group of 2 to 20 carbon atoms )" into the carbon nano tube, which includes a1) applying acid treatment to the carbon nano tube and a2) performing esterification by adding polyhydric alcohol (polyol) to the acid-treated carbon nano tube; and
b) mixing the carbon nano tube having the functional group of "-COOR" prepared at the a) with an organic binder.

10. The method according to claim 9, wherein the acid treatment may be achieved by adding the carbon nano tube to solution where H₂SO₄ and HNO₃ are mixed at a volume ratio of 3:1.

11. The method according to claim 9, wherein, in the a2), the carbon nano tube having the functional group of "-COOR" is produced through esterification achieved by adding the carbon nano tube, into which a carboxy group of "-COOH" is introduced by the acid treatment of the a1), to the polyol of a liquid type.

12. The method according to claim 9, wherein the polyol comprises methyl methacrylate diol and ester terephthalate diol.

13. The method according to claim 9, wherein the carbon nano tube having the functional group of "-COOR" comprises at least one carbon nano tube selected between a multi-walled nano tube (MWNT) and a single-walled nano tube (SWNT).

14. The method according to claim 9, wherein, in the b), 1 to 10 parts by weight of the carbon nano tube having the functional group of "-COOR" and 90 to 99 parts by weight of an organic binder are mixed with respect to 100 parts by weight of a total composite.

15. The method according to claim 9, wherein, in the b), graphite is further added, and
in the b), 1 to 10 parts by weight of the carbon nano tube having the functional group of "-COOR," 70 to 89 parts by weight of the organic binder, and 10 to 20 parts by weight of the graphite are mixed with respect to 100 parts by weight of a total composite.

16. The method according to claim 14 or 15, wherein if a mixture obtained in the b) corresponds to 40 to 90 parts by weight with respect to 100 parts by weight of the total composite, a solvent corresponding to 10 to 60 parts by weight is added.
